# EUROPEAN PATENT APPLICATION

(11) **EP 3 882 699 A1**
(43) Date of publication of application: **22.09.2021**
(21) Application number: 19885065.3
(22) Date of filing: 26.09.2019
(51) Int. Cl.: G03F 7/20, G02B 26/12

(54) **CALIBRATION SYSTEM AND DRAWING DEVICE**

(30) Priority: 15.11.2018 JP 2018215104
(71) Applicant: Inspec Inc., Senboku City Akita, 014-0341 (JP)
(72) Inventor: SUGAWARA, Masashi, Senboku City, Akita 014-0341 (JP)
(74) Representative: Winter, Brandl - Partnerschaft mbB
(86) International application number: PCT/JP2019/037994
(87) International publication number: WO 2020/100446

(57) **Abstract**

A calibration system, etc. is provided that is capable of performing calibration as needed in the case of forming a continuous pattern on a long sheet-like substrate. The calibration system includes: an exposure head support part that supports an exposure head so that a beam for exposure is incident on a predetermined exposure region on the substrate at the time of exposure; a sensor unit that includes an optical sensor; a sensor unit support part that supports the sensor unit so that, at the time of exposure, a light-receiving surface of the optical sensor is parallel to an exposure surface in the exposure region and the sensor unit support part is installed slidably relative to the exposure head support part; a movement mechanism that moves the exposure head support part and the sensor unit support part; and a control part. The control part moves, at the time of calibration, the exposure head support part and the sensor unit support part so as to arrange the light-receiving surface at a position corresponding to the exposure surface on which the beam is incident at the time of exposure.

## Description

### TECHNICAL FIELD

The present invention relates to calibration systems for calibrating an exposure head that emits an exposure light beam for drawing a pattern on a substrate and to drawing devices.

### BACKGROUND ART

In recent years, the amount of electronics used in transportation machines such as automobiles and aircraft has been steadily increasing. Along with this, the number of wire harnesses used for power supply and/or signal transmission and reception with respect to the electronics is also increasing. On the other hand, weight reduction and internal space saving are required in the transportation machines, and an increase in weight and space occupation due to the increase of the wire harnesses is therefore becoming a problem.

In view of these problems, investigations have been made to replace the wire harnesses used in transportation machines with long sheet-like flexible printed circuits (FPCs).

As a technique for forming patterns on a long sheet-like substrate, for example, PTL 1 discloses a pattern-forming device that forms a pattern in a plurality of regions of a surface of a long sheet material by means of scanning exposure in which the sheet material is scanned and moved along a first axis parallel to the longitudinal direction while the sheet material is irradiated with an energy beam corresponding to a predetermined pattern. In this pattern-forming device, the exposure is performed by projecting an image of a pattern formed on a mask onto the sheet material.

Further, PTL 2 discloses a drawing device that draws a predetermined pattern for each of a plurality of regions divided in a width direction perpendicular to a longitudinal direction of a substrate while conveying the substrate in the longitudinal direction. In this PTL 2, the exposure is performed by the direct drawing method (raster scan method) which does not use a mask.

NPTL 1 discloses a technique of performing alignment measurement, overlay exposure and workpiece replacement in parallel, in order to perform a process while continuously conveying the film by a roll-to-roll method without stopping the film from being conveyed.

### PRIOR ART DOCUMENTS

### PATENT LITERATURE

PTL 1: JP2011-22583 A
PTL 2: JP2017-102385 A

### NON-PATENT LITERATURE

NPTL 1: Yoshiaki Kito, et al., "Direct Imaging Exposure Equipment with High Overlay Accuracy for Flexible Substrate in Roll-to-Roll Method," Journal of the Institute of Image Information and Television Engineers, Vol. 71, No. 10, pp. J230-J235 (2017), the Institute of Image Information and Television Engineers, September 8, 2017

### SUMMARY OF THE INVENTION

### PROBLEMS TO BE SOLVED BY THE INVENTION

For example, in order to replace the wire harnesses used in an automobile with FPCs, it is necessary to form a continuous wiring pattern of several meters in length (e.g., 6 m or more) on a substrate. However, PTL 1 and 2 disclose only techniques for forming a pattern for a relatively small electronic device, such as a flexible display or a flexible sensor. Therefore, in order to form a continuous long wiring pattern using the techniques disclosed in PTL 1 and 2, it is necessary to align and join the exposed patterns each time one pattern is exposed, which is labor-intensive, time-consuming and inefficient. On the other hand, NPTL 1 describes that a long, continuous pattern can be produced because exposure can be performed continuously without stopping the conveyance device and there is no limitation as to the pattern size due to masks.

Incidentally, in equipment requiring a high level of safety, such as automobiles and aircraft, traceability is required to ensure the high reliability of each component constituting the transportation machine. For this reason, regarding the patterned substrate, in the step of patterning the substrate, it is necessary to periodically calibrate the exposure head for emitting a beam for exposure and store the calibration data.

In this regard, when pattern formation is performed intermittently with respect to a plurality of regions on a substrate as in PTL 1 and 2, calibration may be performed by utilizing a space on the same substrate between pattern formation. However, when pattern formation is performed continuously on a substrate as in NPTL 1, calibration cannot be performed halfway with the substrate being set in the exposure device.

The present invention has been made in view of the above, and an object of the present invention is to provide a calibration system and a drawing device that are capable of performing, as needed, calibration of an exposure head which emits an exposure beam for drawing a pattern in the case of continuously forming a pattern on a long sheet-like substrate.

### MEANS FOR SOLVING THE PROBLEMS

In order to solve the above problems, a calibration system according to an aspect of the present invention is a calibration system for calibrating at least one exposure head that irradiates a substrate having a long-sheet shape with a beam for exposure, the substrate being conveyed along a longitudinal direction, comprising: an exposure head support part that supports the at least one exposure head, the exposure head support part being configured to be arranged, at the time of exposure, at a position at which the beam emitted from each of the at least one exposure head is to be incident on at least one predetermined exposure region on the substrate; at least one sensor unit that includes an optical sensor, the optical sensor including a light-receiving surface that receives the beam and detecting at least an irradiation position and an irradiation intensity of the beam incident on the light-receiving surface; a sensor unit support part that supports the at least one sensor unit, the sensor unit support part supporting the at least one sensor unit so that, at the time of exposure, the light-receiving surface of the optical sensor included in the at least one sensor unit is parallel to an exposure surface in the at least one predetermined exposure region and the sensor unit support part is installed slidably relative to the exposure head support part; a movement mechanism that is configured to move at least the exposure head support part out of the exposure head support part and the sensor unit support part; and a control part configured to control operation of the movement mechanism, wherein the control part is configured to move, at the time of calibration, the exposure head support part so as to create a space in which the at least one sensor unit can be arranged on an optical path of the beam emitted from the at least one exposure head, and to move the sensor unit support part to slide relatively with respect to the exposure head movement part so as to arrange the light-receiving surface at a position corresponding to the exposure surface on which the beam emitted from the at least one exposure head is incident at the time of exposure.

In the above-described calibration system, the movement mechanism may include: an exposure head movement part that is configured to create the space by lifting one end side of the exposure head support part using the other end side as a rotary shaft; and a slide movement part that is configured to slide the sensor unit support part relative to the exposure head support part.

In the above-described calibration system, the sensor unit support part may be provided at a position fixed relative to a conveying mechanism for conveying the substrate, and the movement mechanism may be configured to move the exposure head support part in translational motion in a direction in which the sliding is possible.

In the above-described calibration system, the movement mechanism may include: an exposure head movement part that creates the space by moving the exposure head support part in translational motion in the vertical direction; and a slide movement part that slides the sensor unit support part relative to the exposure head support part.

In the above-described calibration system, the control part may be configured to cause the beam to be emitted from the at least one exposure head toward the light-receiving surface and to generate, based on a detection signal output from the sensor unit, data representing the irradiation position and the irradiation intensity at the light-receiving surface of the beam emitted from the at least one exposure head and the calibration system may further comprises a storage part that is configured to store the data representing the irradiation position and the irradiation intensity as calibration data.

In the above-described calibration system, the storage part may be configured to further store reference data representing a reference irradiation position and a reference irradiation intensity of the beam with respect to the at least one exposure region, and the control part may include a determination part that is configured to determine, based on the calibration data and the reference data, whether or not an irradiation position and an irradiation intensity of a beam emitted from the at least one exposure head fall within ranges of predetermined reference values.

In the above-described calibration system, the control part may be configured to generate, based on the determination result by the determination part, correction value data for correcting at least either the irradiation position or the irradiation intensity of the beam emitted from the at least one exposure head if at least either the irradiation position or the irradiation intensity of the beam emitted from the at least one exposure head fails to fall within the range of the reference value, and the storage part may be configured to further store the correction value data.

In the above-described calibration system, each of the at least one exposure heads may include: a light source that outputs the laser light; an optical system that shapes the laser light into a beam shape; a polygon mirror that causes the laser light shaped into the beam shape to scan; and a drive part that rotates the polygon mirror, wherein the control part may be configured to correct at least either the irradiation intensity or the irradiation position of the beam emitted from the at least one exposure head by controlling at least either the output of the light source or operation of the drive part based on the correction value data.

A drawing device according to another aspect of the present invention includes: the above-described calibration system; at least one exposure head supported by the exposure head support part; and a conveying drum that has a cylindrical shape, the conveying drum supporting the substrate on an outer periphery and conveying the substrate by rotating about a central shaft of the cylinder.

### EFFECT OF THE INVENTION

According to the present invention, at the time of calibration, a space is created in which the sensor unit can be arranged on the optical path of the beam emitted from the exposure head by moving the exposure head support part, and the light-receiving surface of the optical sensor is arranged at a position corresponding to the exposure surface on which the beam emitted from the exposure head is incident at the time of exposure by relatively sliding the sensor unit support part relative to the exposure head movement part. Thereby, information can be acquired regarding an irradiation position and an irradiation intensity of a beam incident on the exposure region on the substrate by detecting the irradiation position and the irradiation intensity of the beam at the light-receiving surface. Therefore, in the case of continuously forming a pattern on a long sheet-like substrate, calibration can be performed, as needed, while the substrate remains set on the conveying drum.

### BRIEF DESCRIPTION OF THE DRAWINGS

[FIG. 1] FIG. 1 is a schematic diagram showing a schematic configuration of a drawing device including a calibration system according to a first embodiment of the present invention.
[FIG. 2] FIG. 2 is a plan view of the drawing device shown in FIG. 1.
[FIG. 3] FIG. 3 is an enlarged schematic diagram showing a drawing unit shown in FIG. 1.
[FIG. 4A] FIG. 4A is a schematic diagram showing a schematic configuration of the inside of an exposure head.
[FIG. 4B] FIG. 4B is a schematic diagram showing a schematic configuration of the inside of an exposure head.
[FIG. 4C] FIG. 4C is a schematic diagram showing a schematic configuration of the inside of the exposure head.
[FIG. 5] FIG. 5 is a schematic diagram of the exposure head shown in FIG. 3 as seen from the substrate side.
[FIG. 6] FIG. 6 is a schematic diagram showing a substrate on which a pattern is formed.
[FIG. 7] FIG. 7 is a schematic diagram showing a state in which an exposure head support part is moved in the drawing unit shown in FIG. 3.
[FIG. 8] FIG. 8 is a schematic diagram showing a state in which a sensor unit is moved with respect to the drawing unit shown in FIG. 7.
[FIG. 9] FIG. 9 is a schematic diagram of the exposure head shown in FIG. 8 as seen from the substrate side.
[FIG. 10] FIG. 10 is a block diagram showing a schematic configuration of a controller shown in FIG. 1.
[FIG. 11] FIG. 11 is a flowchart illustrating the operation of the drawing device at the time of calibration.
[FIG. 12] FIG. 12 is a schematic diagram showing a schematic configuration of a drawing unit including a calibration system according to a second embodiment of the present invention.
[FIG. 13] FIG. 13 is a schematic diagram showing a schematic configuration of a drawing unit including a calibration system according to a third embodiment of the present invention.

### EMBODIMENTS OF THE INVENTION

Hereinafter, a calibration system and a drawing device according to embodiments of the present invention will be described with reference to the drawings. It should be noted that the present invention is not limited by these embodiments. In the description of each drawing, the same portions are denoted by the same reference numbers.

The drawings referred to in the following description are merely schematic representations of shape, size, and positional relationship to the extent that the subject matter of the present invention may be understood. In other words, the present invention is not limited only to the shapes, sizes, and positional relationships exemplified in the respective figures. In addition, the drawings may also include, among themselves, portions having different dimensional relationships and ratios from each other.

### First embodiment

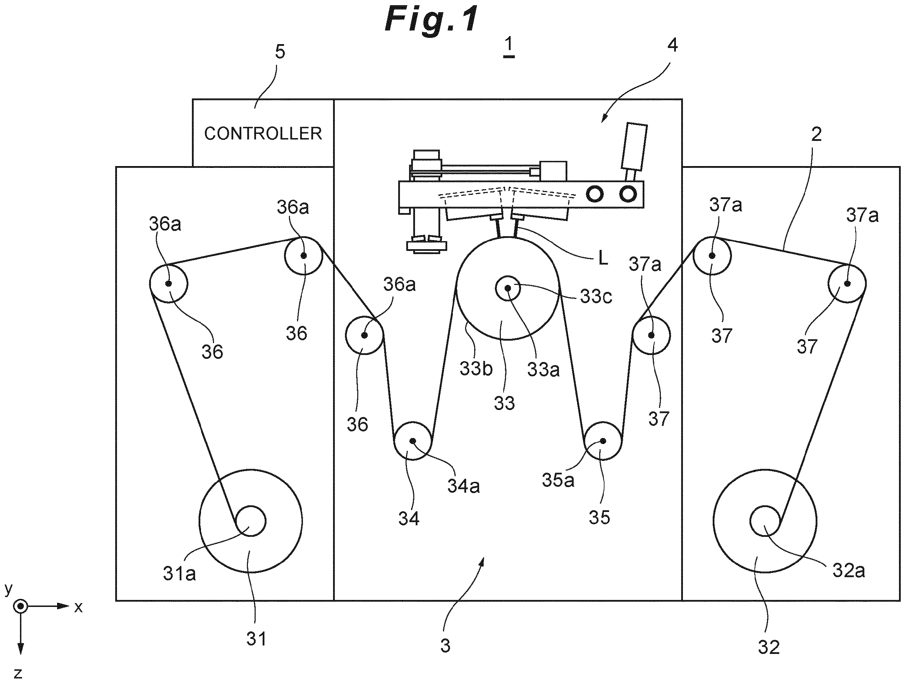

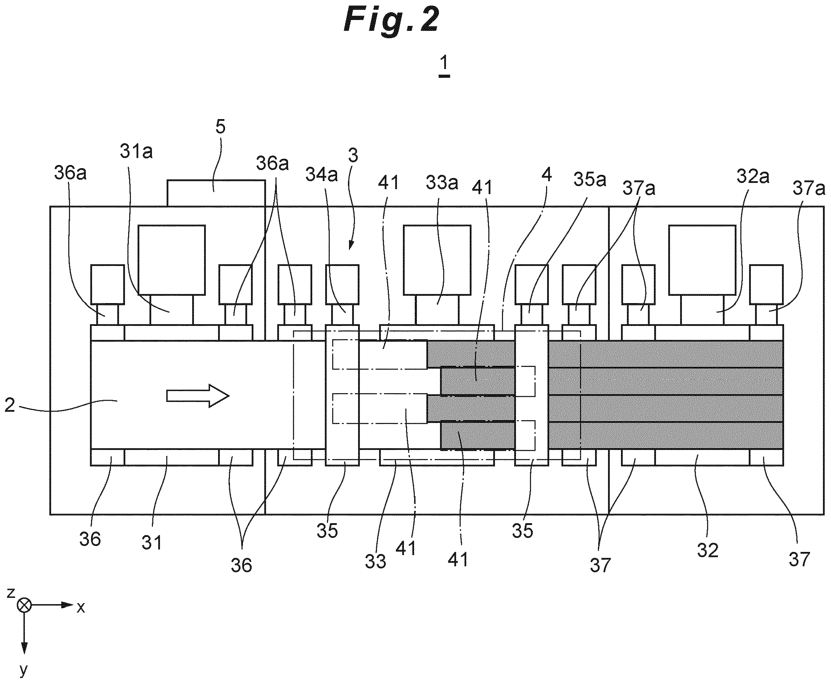

FIG. 1 is a schematic diagram showing a schematic configuration of a drawing device including a calibration system according to a first embodiment of the present invention. FIG. 2 is a plan view of the drawing device. As shown in FIGS. 1 and 2, the drawing device 1 includes a conveying system 3 for conveying a substrate 2 having a long sheet shape, a drawing unit 4 for forming a pattern by irradiating the substrate 2 with a beam L for exposure, and a controller 5 for controlling the operation of the conveying system 3 and the drawing unit 4.

In the present embodiment, a flexible printed circuit (FPC) is used as the substrate 2 to be processed. The FPC is a flexible circuit substrate in which a metal foil such as copper is bonded to a base film made of an insulating resin such as polyimide. The substrate 2 is, for example, a strip-shaped FPC of several meters to several tens of meters in length, and the substrate is unwound from a state of being wound in a roll on an unwinding reel 31 and is wound on a take-up reel 32 after being conveyed by the conveying system 3 and a patterned is formed thereon by the drawing unit 4. Thus, this method of conveying in which the strip-shaped workpiece is unwound from a roll and wound around a roll after application of predetermined processing is referred to as a "roll-to-roll" method.

In the conveying system 3, a rotary shaft 31a for rotatably supporting the unwinding reel 31, a rotary shaft 32a for rotatably supporting the take-up reel 32, a conveying drum 33, tension pulleys 34, 35 provided respectively on the upstream side (left side in the figure) and the downstream side (right side in the figure) of the conveying drum 33, and a plurality of guide rollers 36, 37 are provided.

The conveying drum 33 generally has a cylindrical shape and is supported by a rotary shaft 33a which rotates by the rotational driving force supplied from a drive source. The conveying drum 33 supports the substrate 2 in a region of substantially the upper half of the outer periphery 33b thereof, and conveys the substrate 2 as the conveying drum rotates. Further, the conveying drum 33 is provided with an encoder 33c for measuring the amount of rotation of the conveying drum 33.

In the following, the conveying direction of the substrate 2 at the upper end portion of the conveying drum 33 will be referred to as the x direction, the direction orthogonal to the x direction in a plane (horizontal plane) in contact with the upper end portion of the conveying drum 33 will be referred to as the y direction (i.e., the width direction of the substrate 2), and the direction orthogonal to the x-y plane (the vertical direction) will be referred to as the z direction (positive in the downward direction).

Two tension pulleys 34, 35 are located below the conveying drum 33 and are located such that they are movable in the vertical direction. In particular, the tension pulleys 34, 35 are respectively rotatably supported on rotary shafts 34a, 35a which are movable in the vertical direction. A tension adjusting mechanism for biasing the rotary shaft 34a, 35a downward is coupled to each rotary shaft 34a, 35a. The substrate 2 wound around the conveying drum 33 can be conveyed with a predetermined tension applied thereon by biasing the tension pulleys 34, 35 downward via the rotary shafts 34a, 35a by means of the tension adjusting mechanism.

Each guide roller 36 is rotatably supported on a rotary shaft 36a and guides the substrate 2 unwound from the unwinding reel 31 to the upstream-side tension pulley 34. Each guide roller 37 is rotatably supported on a rotary shaft 37a and guides the substrate 2 that has been applied with pattern-forming processing from the downstream-side tension pulley 35 to the take-up reel 32.

The configuration of the conveying system 3 is not limited to the configurations shown in FIGS. 1 and 2, as long as the substrate 2 is conveyed in the roll-to-roll method and the pattern-forming processing can be applied to the substrate 2 supported on the outer periphery 33b of the conveying drum 33. Further, a unit (a preprocessing unit, a post-processing unit, etc.) may be provided for performing different processing between unwinding of the substrate 2 from the unwinding reel 31 and reaching thereof to the conveying drum 33, or between removal of the substrate 2 from the conveying drum 33 and winding thereof on the take-up reel 32. Typically, an edge position control (EPC) device is provided which detects the edge position of the substrate 2 and finely moves the unwinding device or the take-up device in the conveying system 3 in order to prevent meandering during conveying of the substrate.

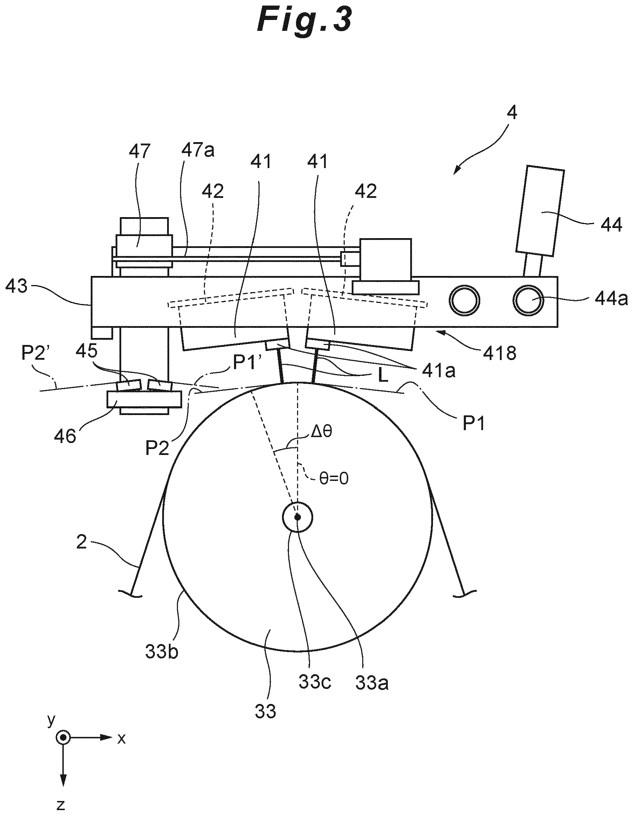

FIG. 3 is an enlarged schematic diagram showing the drawing unit shown in FIG. 1. As shown in FIG. 3, the drawing unit 4 includes an exposure head 41 for emitting a beam L for exposure, an adjustment stage 42, an exposure head support part 43, an exposure head movement part 44, a sensor unit 45, a sensor unit support part 46, and a sensor unit movement part 47. A support stage 48 to which the exposure head 41 is mounted is fixed inside the exposure head support part 43. Among these, the exposure head support part 43, the exposure head movement part 44, the sensor unit 45, the sensor unit support part 46, and the sensor unit movement part 47, and a controller 5, which is to be described later, constitute a calibration system according to the present embodiment.

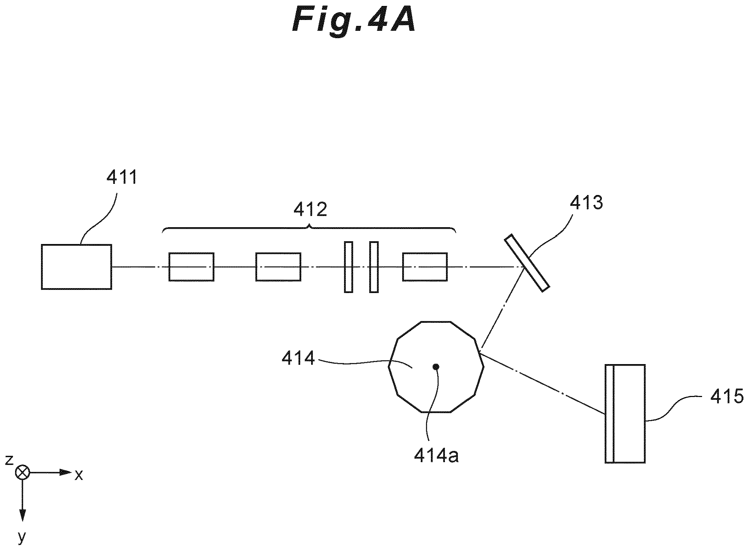

The exposure head 41 directly draws a pattern, such as a circuit or a wiring, on the substrate 2 by radiating the beam L toward the substrate 2 supported on the conveying drum 33. FIGS. 4A to 4C are schematic diagrams showing schematic configurations of the inside of the exposure head.

As shown in FIGS. 4A to 4C, a laser light source 411 for outputting laser light, a beam-shaping optical system 412, reflecting mirrors 413, 415, a polygon mirror 414, and an fθ lens 416 are provided inside the exposure head 41. The polygon mirror 414 is provided with a drive device for rotating the polygon mirror 414 about a rotary shaft 414a.

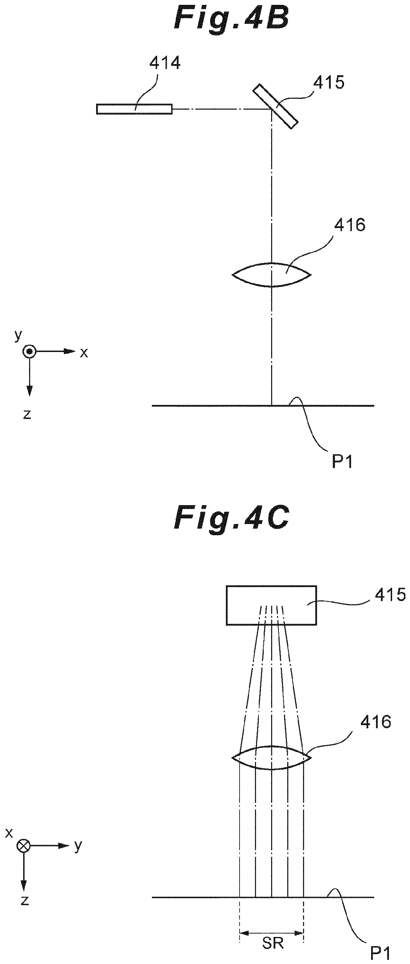

The beam-shaping optical system 412 includes an optical element, such as a collimator lens, a cylindrical lens, a light amount adjusting filter, and a polarizing filter, and shapes the laser light output from the laser light source 411 to the beam L having a spot-shaped beam shape. The reflecting mirror 413 reflects the beam L shaped by the beam-shaping optical system 412 in the direction of the polygon mirror 414. The polygon mirror 414 rotates around the rotary shaft 414a and reflects the beam L incident from the direction of the reflection mirror 413 in a plurality of directions in the x-y plane. The reflecting mirror 415 reflects the beam L reflected by the polygon mirror 414 in a direction orthogonal to the incident direction (see the beam emitting port 41a in FIG. 3) and causes it to be incident on the fθ lens 416. The fθ lens 416 causes the incident beam L to be imaged on an exposure surface P1, P2 (see FIG. 3) of the substrate 2 supported on the outer periphery of the conveying drum 33. In such exposure head 41, the beam L emitted from the exposure head 41 can be caused to scan one-dimensionally in a predetermined scan range SR (see FIGS. 4B and 4C) by controlling the rotation of the polygon mirror 414.

Referring again to FIG. 3, the adjustment stage 42 is provided for manually fine-adjusting the position of the exposure head 41 in the x and y directions, and the angle with respect to the vertical direction. The exposure head support part 43 supports the exposure head 41 and the adjustment stage 42 such that the beam L emitted from the exposure head 41 is incident on a predetermined exposure region of the substrate 2.

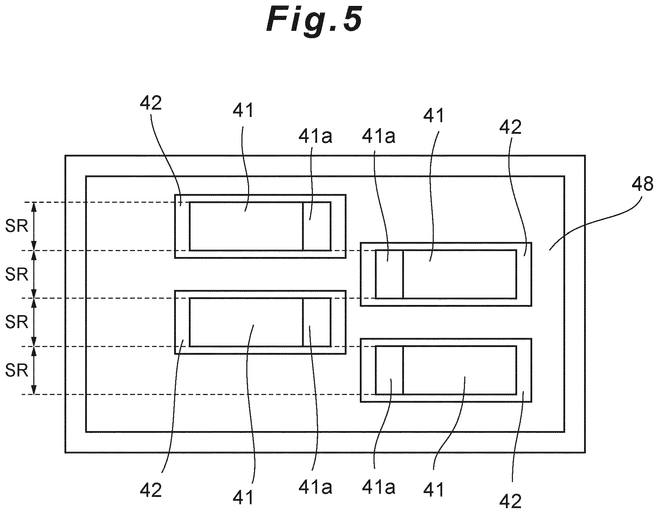

FIG. 5 is a plan view of the exposure head 41 as seen from the substrate 2 side. As shown in FIG. 5, four exposure heads 41 are mounted to the support stage 48 provided inside the exposure head support part 43 via respective adjustment stages 42. The four exposure heads 41 are arranged such that the edges of the scan ranges SR (see FIG. 4C) of the adjacent beams L slightly overlap each other or are adjacent to each other without any space therebetween in the width direction (the y direction) of the substrate 2. Thereby, scanning can be performed without any space by means of the four beams L in the width direction of the substrate 2.

It should be noted that, although four exposure heads 41 are provided in the drawing unit 4 in FIGS. 2 and 5, the number of exposure heads 41 is not limited thereto. The number of exposure heads 41 may be one or more, and can be appropriately determined according to the width of the substrate 2, the scan range SR and the output of the exposure head 41, and the like.

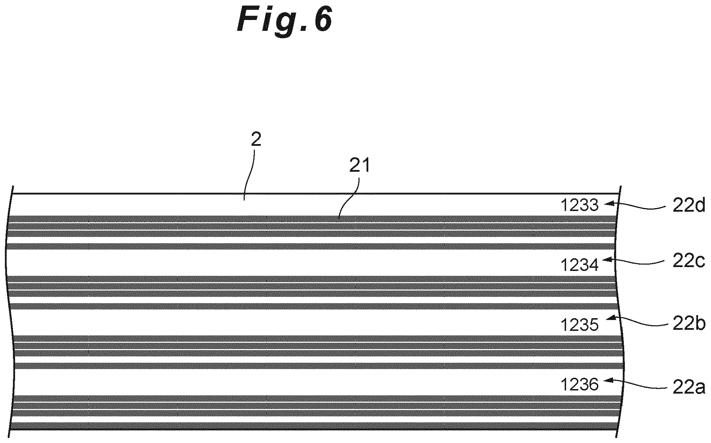

FIG. 6 is a schematic diagram showing the substrate 2 on which a pattern is formed by the drawing unit 4. The two-dimensional exposure pattern 21 is formed on the substrate 2 by conveying the substrate 2 by means of the conveying drum 33 while the beam L emitted from each exposure head 41 is scanned in the width direction of the substrate 2 as shown in FIG. 5. In this way, a continuous exposure pattern 21 can be formed without interruption on the long substrate 2 by conveying the substrate 2 while the substrate 2 is irradiated with the beam L and and the direct drawing is performed.

In addition, a region to be exposed by each exposure head 41 may be set in advance in the substrate 2. Therefore, an identification mark (ID) 22 for identifying an individual product (pattern) may be drawn in the exposure region of each exposure head 41. A high level of traceability can be ensured by managing the identification mark 22 in association with data such as a lot number, a drawing device number, an exposure head number, and/or a date and time of exposure.

Referring again to FIG. 3, the exposure head movement part 44 and the sensor unit movement part 47 correspond to a movement mechanism for moving the exposure head support part 43 and the sensor unit support part 46 at the time of calibration. The exposure head support part 43 is installed rotatably to the exposure head movement part 44 via a rotary shaft 44a arranged in a shaft hole formed at an end portion of the exposure head support part 43.

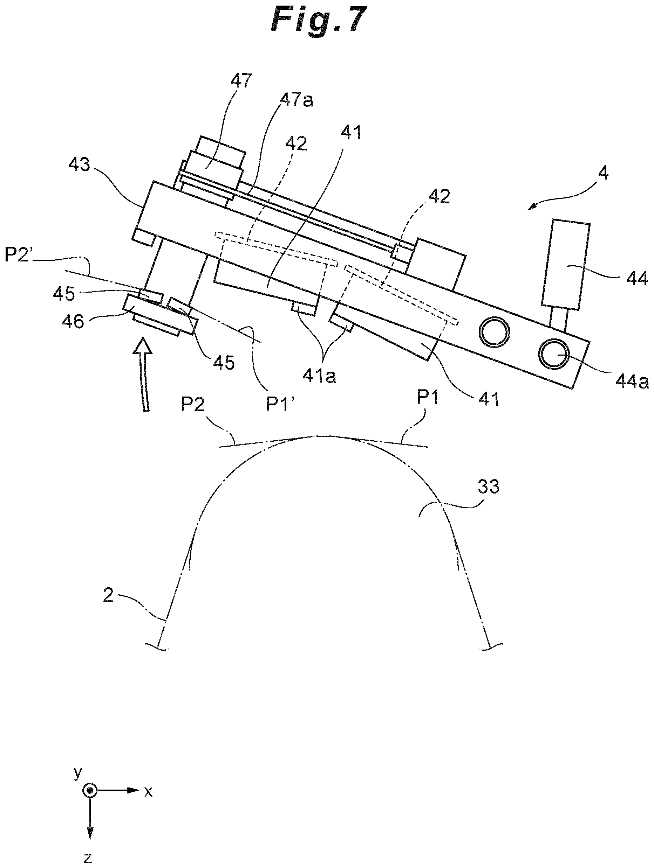

FIG. 7 is a schematic diagram showing a state in which the exposure head support part 43 is moved. As shown in FIG. 7, the exposure head support part 43 can be moved by lifting the exposure head support part 43 in such a manner that one end side thereof rotates around the rotary shaft 44a provided on the other end side thereof. When the exposure head support part 43 is moved in this manner, a space is created in which the sensor unit support part 46, which will be described later, can be arranged on the optical path of the beam L emitted from the exposure head 41.

The sensor unit 45 is used for calibration of the beam L emitted from the exposure head 41. The sensor unit 45 includes an optical sensor, such as a position detecting element (PSD), which has a two-dimensional light-receiving surface for receiving the beam L and detects at least an irradiation position and an irradiation intensity of the beam L with respect to the light-receiving surface, and a sensor substrate on which a circuit is formed for supplying power to the optical sensor, as well as for transmitting a signal output from the optical sensor. In the present embodiment, four sensor units 45 are provided, each sensor unit detecting a corresponding one of the beams L emitted from the four exposure heads 41.

The sensor unit support part 46 supports the sensor unit 45 and is slidably supported by the exposure head support part 43 via the sensor unit movement part 47, which will be described later. Specifically, the sensor unit support part 46 supports the sensor unit 45 so that the light-receiving surface (see plane P1', P2') of the optical sensor provided in each sensor unit 45 is parallel to the exposure surface P1, P2 in the exposure region of the corresponding exposure head 41 at the time of exposure. The exposure surface P1, P2 herein refers to a surface in contact with the incident point (the irradiation position) of the beam L incident on the surface of the substrate 2 supported on the outer periphery 33b of the conveying drum 33.

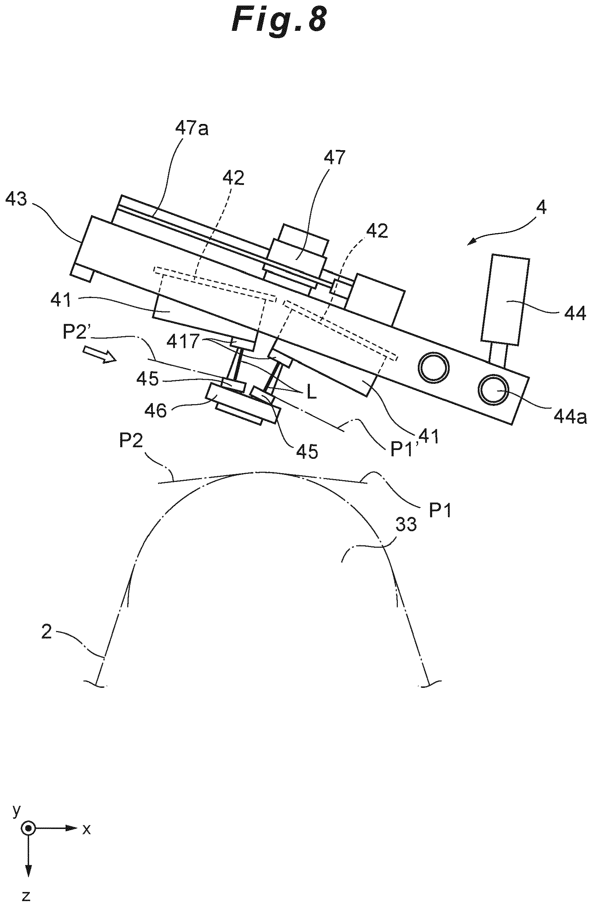

The sensor unit movement part 47 slides the sensor unit support part 46 with respect to the exposure head support part 43. FIG. 8 is a schematic diagram showing a state in which the sensor unit support part 46 is moved with respect to the drawing unit 4 shown in FIG. 7. The sensor unit movement part 47 is installed to a slide rail 47a fixed to the exposure head support part 43. By moving the sensor unit movement part 47 along the slide rail 47a, the sensor unit support part 46 supported by the sensor unit movement part 47 also moves in translational motion. As shown in FIG. 8, when the sensor unit support part 46 is moved, the light-receiving surface of the optical sensor provided in the sensor unit 45 is arranged at a position corresponding to the exposure surface P1, P2 where the beam L emitted from the corresponding exposure head 41 is to be incident at the time of exposure.

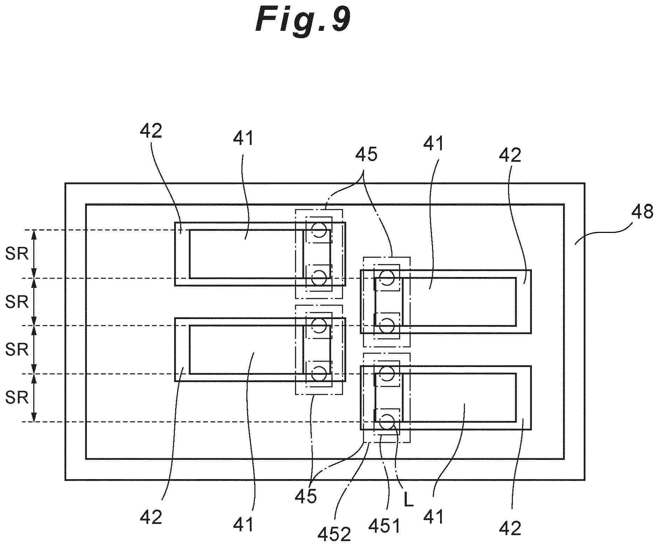

FIG. 9 is a schematic diagram of the exposure head 41 shown in FIG. 8 as seen from the substrate side. As shown in FIG. 9, two optical sensors 451 are arranged on the sensor substrate 452 of each sensor unit 45. The positions of these optical sensors 451 are set so that the center line of each optical sensor 451 overlaps the line of the edge of the scan range SR. In this way, a slight deviation in the x direction of the irradiation position of the beam L can be detected by providing the two optical sensors 451 to the sensor unit 45 that performs calibration of one exposure head 41.

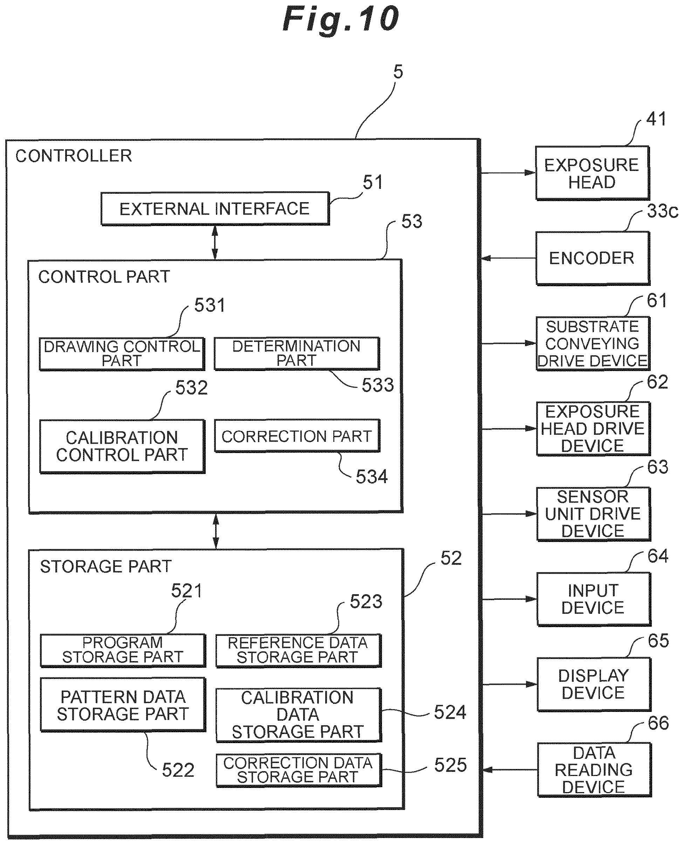

FIG. 10 is a block diagram showing a schematic configuration of the controller 5. The controller 5 is a device for comprehensively controlling the operation of each component of the drawing device 1, and includes an external interface 51, a storage part 52, and a control part 53.

The external interface 51 is an interface for connecting various external devices to the controller 5. Examples of the external devices connectable to the controller 5 include the exposure head 41, the encoder 33c, a substrate conveying drive device 61 for driving the conveying system 3, an exposure head drive device 62 for driving the exposure head movement part 44, a sensor unit drive device 63 for driving the sensor unit movement part 47, an input device 64 such as a keyboard or a mouse, a display device 65 such as a liquid crystal monitor, and a data reading device 66 for loading pattern data or the like into the controller 5.

The storage part 52 is configured by using a computer readable storage medium such as a disk drive or a solid-state memory (e.g. a ROM or RAM). The storage part 52 stores, in addition to an operating system program and a driver program, a program for causing the controller 5 to execute a predetermined operation, various types of data and setting information used during execution of the program, and the like. Specifically, the storage part 52 includes: a program storage part 521 for storing the various above-described programs; a pattern data storage part 522 for storing data of a pattern to be drawn by the drawing unit 4; a reference data storage part 523 for storing reference data of the irradiation position and the irradiation intensity of the beam L; a calibration data storage part 524 for storing calibration data of the exposure head 41; and a correction data storage part 525 for storing correction data for adjusting the exposure head 41 based on the calibration data.

The reference data storage part 523 stores, as the reference data, the irradiation position and the irradiation intensity of the beam L (i.e., the reference irradiation position and the reference irradiation intensity) which are set so that appropriate exposure is performed on the exposure region of the substrate 2 supported on the outer periphery 33b of the conveying drum 33. Further, the reference data storage part 523 may store predetermined reference values which are set based on the reference irradiation position and the reference irradiation intensity. Here, the reference values refer to the irradiation position and the irradiation intensity including errors allowed in the beam L with which the exposure region is actually irradiated, with respect to the reference irradiation position and the reference irradiation intensity. The correction data stored in the correction data storage part 525 is data generated when at least either the irradiation position or the irradiation intensity of the beam L fails to fall within the range of the reference value, and is data for correcting at least either the irradiation position or the irradiation intensity of the beam L.

The control part 53 is configured by using hardware such as a central processing unit (CPU), and reads and executes the program stored in the program storage part 521 to perform data transfer and instruction to each component of the controller 5 and the drawing device 1, and comprehensively controls the operation of the drawing device 1 to execute the pattern-forming processing on the substrate 2. Further, by executing the calibration program stored in the program storage part 521, the control part 53 periodically performs calibration of the exposure head 41, stores the calibration data, and adjusts the exposure head 41 based on the calibration data.

Specifically, functional parts implemented by the control part 53 executing the calibration program include a drawing control part 531, a calibration control part 532, a determination part 533, and a correction part 534.

The drawing control part 531 reads the pattern data from the drawing data storage part 522, generates control data such as the scanning of the beam L in each exposure head 41 and the conveying speed of the substrate 2 by the conveying system 3, and outputs the control data to the exposure head 41 and the substrate conveying drive device 61. Thereby, a predetermined exposure region of the substrate 2 is irradiated with the beam L emitted from each exposure head 41 and is scanned with the beam L in the width direction while the substrate 2 is conveyed at a predetermined speed by the conveying system 3. In this manner, a two-dimensional pattern is continuously formed on the substrate 2.

The calibration control part 532 performs control for calibrating the exposure head 41 at a predetermined timing and generates data (calibration data) representing the measured values (calibration values) of the irradiation position and the irradiation intensity of the beam L at the light-receiving surface of the optical sensor 451.

The determination part 533 determines whether or not the calibration values are within the reference values based on the reference data stored in the reference data storage part 523 and the calibration data.

The correction part 534 generates correction data for correcting the irradiation position and the irradiation intensity of the beam L if the calibration values fail to fall within the reference values, and controls each component based on the correction data.

It should be noted that the controller 5 may be configured by a single piece of hardware or may be configured by combining a plurality of pieces of hardware.

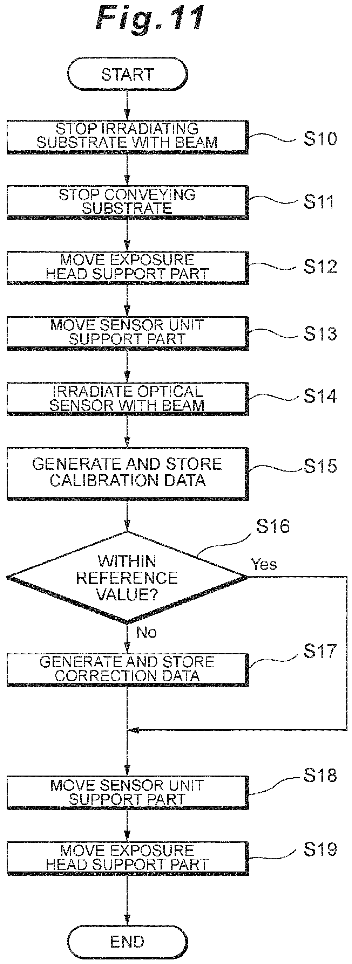

Next, a calibration method according to a first embodiment of the present invention will be described. FIG. 11 is a flowchart illustrating the calibration operation of the drawing device 1.

First, in step S10, the controller 5 causes each exposure head 41 to stop irradiating the substrate 2 with the beam L.

In the subsequent step S11, the controller 5 causes the conveying system 3 to stop conveying the substrate 2.

In the subsequent step S12, the controller 5 drives the exposure head drive device 62 to move the exposure head support part 43 by means of the exposure head movement part 44 (see FIG. 7). This creates a space below the exposure head 41 where the sensor unit 45 can be arranged.

In the subsequent step S13, the controller 5 drives the sensor unit drive device 63 to slide the sensor unit support part 46 by means of the sensor unit movement part 47 (see FIG. 8). Thereby, the light-receiving surface of the optical sensor 451 provided in the sensor unit 45 corresponding to a relevant exposure head 41 is arranged at a position (see plane P1', P2') corresponding to the exposure surface P1, P2 upon which the beam L emitted from the relevant exposure head 41 is to be incident at the time of exposure.

In the subsequent step S14, the controller 5 causes each exposure head 41 to irradiate the light-receiving surface of the optical sensor 451 with the beam L. Thereby, each optical sensor 451 detects the irradiation position and irradiation intensity of the beam L incident on the light-receiving surface, and outputs a detection signal.

In the subsequent step S15, the calibration control part 532 of the controller 5 generates, based on the detection signal output from each optical sensor 451, data (calibration data) representing the measured values of the irradiation position and the irradiation intensity of the beam L radiated onto each optical sensor 451 and stores such data in the calibration data storage part 524.

In the subsequent step S16, the determination part 533 compares the calibration data generated in step S15 with the reference data stored in the reference data storage part 523 in order to determine whether or not the irradiation position and the irradiation intensity of the beam L emitted from each exposure head 41 are within the reference values. Specifically, the determination part 533 calculates the difference (Δx, Δy) of the measured value of the irradiation position with respect to the reference irradiation position of the beam L and the difference of the measured value of the irradiation intensity with respect to the reference irradiation intensity. Then, a determination is made as to whether or not the difference of the irradiation position (Δx, Δy) and the difference of the irradiation intensity are equal to or less than predetermined thresholds.

If the irradiation position and the irradiation intensity of the beam L are within the reference values (step S16: Yes), i.e. if the differences are equal to or less than the thresholds, the operation proceeds to step S18.

On the other hand, if the irradiation position and the irradiation intensity of the beam L exceed the reference values (step S16: No), i.e. if the differences exceed the thresholds, the correction part 534 generates correction data for correcting the position and the output of each exposure head 41 and stores such correction data in the correction data storage part 525 (step S17). At this time, the correction part 534 may display the correction data on the display device 66. Specifically, regarding the difference Δx, the correction part 534 corrects the parameter of the output start position (the value of θ at the time of starting the output of the beam L) with respect to the drawing start point that is set using the signal (see Δθ in FIG. 3) of the encoder 33c provided in the conveying drum 33. Further, regarding the difference Δy, the correction part 534 corrects the parameter of the output start position (the initial position of the polygon mirror at the time of starting the output of the beam L) with respect to the drawing start point serving as a reference of the beam L emitted via the polygon mirror 414 (see FIG. 4A). Further, regarding the irradiation intensity, the correction part 534 corrects the output parameter for each exposure head 41 in the drawing control part 531.

In the subsequent step S18, the controller 5 drives the sensor unit drive device 63 to slide the sensor unit support part 46 in a direction away from the exposure head 41 by means of the sensor unit movement part 47.

In the subsequent step S19, the controller 5 drives the exposure head drive device 62 to move the exposure head support part 43 by means of the exposure head movement part 44 to return to the original position at the time of the exposure. Thereafter, the calibration operation in the drawing device 1 ends. When the drawing operation is restarted after completion of the calibration, each component operates based on the parameters corrected in step S17, and the drawing can be performed with the corrected irradiation position and irradiation intensity of the beam.

As described above, according to the first embodiment of the present invention, since the beam L emitted from each exposure head 41 is scanned in the width direction as the beam L is directly radiated onto the substrate 2 while the substrate 2 is conveyed by the conveying drum 33, a two-dimensional exposure pattern therefore can be continuously formed without interruptions on the substrate 2. Therefore, a continuous pattern can be efficiently formed on a long substrate ranging from several meters to several tens of meters in length, and an improvement in throughput can be achieved.

Further, according to the first embodiment of the present invention, a high level of traceability can be ensured at the pattern or wiring level by drawing an identification mark in the exposure region of each exposure head 41 with such exposure head 41.

Further, according to the first embodiment of the present invention, since a light source is provided in each exposure head 41, pattern-forming can be performed with sufficient irradiation intensity.

Further, according to the first embodiment of the present invention, the light-receiving surface of the optical sensor 451 can be accurately arranged at a position corresponding to the exposure surface P1, P2, upon which the beam L emitted from the exposure head is incident at the time of exposure, by sliding the sensor unit support part 46 relative to the exposure head support part 45 at the time of calibration. Therefore, high-precision calibration can be performed by radiating the beam L onto the optical sensor 451 instead of the substrate 2 supported by the conveying drum 33. Accordingly, in the case of forming a continuous pattern on a long substrate 2, calibration can be performed as needed while the substrate 2 remains supported on the conveying drum 33.

Further, according to the first embodiment of the present invention, since the exposure head support part 43 is moved by lifting the end portion thereof by rotating such end portion around the rotary shaft 44a, the calibration system can be configured in a space-saving manner and with low cost.

In the above-described first embodiment, the determination is made as to whether or not the calibration value of the beam L falls within the range of the reference value, and various types of processing for performing correction are executed if the calibration value fails to fall within the range of the reference value. However, it may be sufficient to perform calibration and simply store the calibration data. Further, it may also be sufficient to store the determination result of the calibration data or the correction data based on the determination result.

Further, in the above-described first embodiment, the position and the inclination of the exposure head 41 are manually fine-adjusted by means of the adjustment stage 42, but an electrically controllable adjustment stage may be provided instead of the adjustment stage 42, and the position and the inclination of the exposure head 41 may be automatically adjusted based on the result of the calibration.

Further, in the above-described first embodiment, the irradiation position and the irradiation intensity of the beam L at the light-receiving surface of the optical sensor 451 are detected, but in addition to these, the irradiation range (beam diameter and beam shape) of the beam L may be detected and stored as calibration data. In this case, focus adjustment may be performed by correcting the position (i.e., the distance to the exposure surface P1, P2) of the exposure head 41 based on the beam diameter detected by the optical sensor 451. Further, the inclination (i.e., the angle formed between the exposure surface P1, P2 and the beam L) of the exposure head 41 may be corrected based on the beam shape detected by the optical sensor 451.

### Second Embodiment

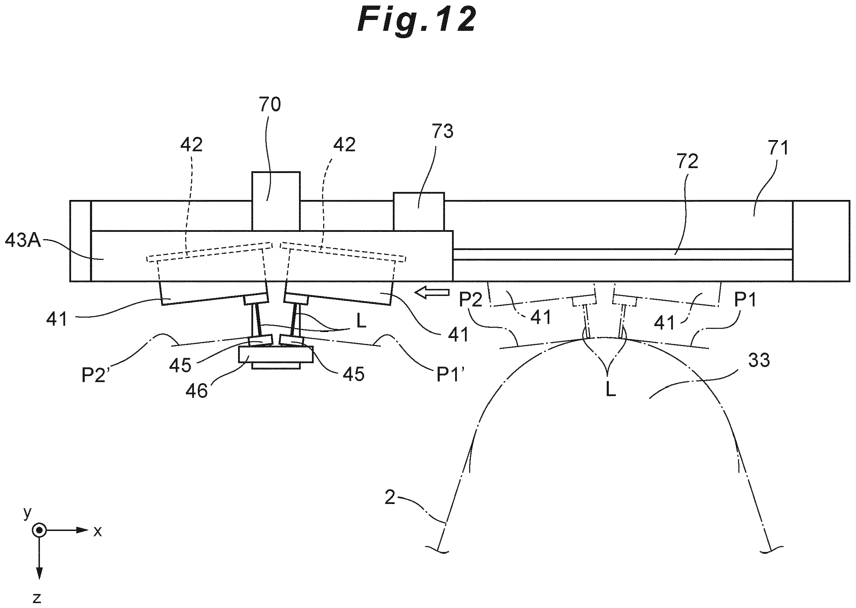

FIG. 12 is a schematic diagram showing a drawing unit including a calibration system according to a second embodiment of the present invention. In the calibration system according to the present embodiment, the position of the sensor unit 45 is fixed, and, at the time of calibration, the exposure head support part 43 for supporting the exposure head 41 is moved in translational motion in the horizontal plane and the beam L emitted from the exposure head 41 is made incident on the optical sensor.

Specifically, the calibration system according to the present embodiment includes an exposure head support part 43A, the sensor unit 45, the sensor unit support part 46, a sensor unit fixing part 70, a joist 71 provided with a slide rail 72, and a drive part 73 for moving the exposure head support part 43A along the slide rail 72. The joist 71 and the drive part 73 constitute a movement mechanism for moving the exposure head support part 43A. The relative positional relationship between the exposure head 41 supported by the exposure head support part 43A and the sensor unit 45 is the same as that of the first embodiment.

When performing calibration, the exposure head support part 43A is slid to move the exposure head 41 to a position where the beam L is to be incident on the light-receiving surface of the optical sensor provided in the sensor unit 45. Thereby, the step of creating a space on the optical path of the beam emitted from the exposure head 41 and the step of placing the sensor unit 45 in such space are performed simultaneously.

According to the second embodiment of the present invention, calibration can be performed by only sliding the exposure head support part 43A, and calibration can therefore be performed at high speed and with high accuracy.

### Third Embodiment

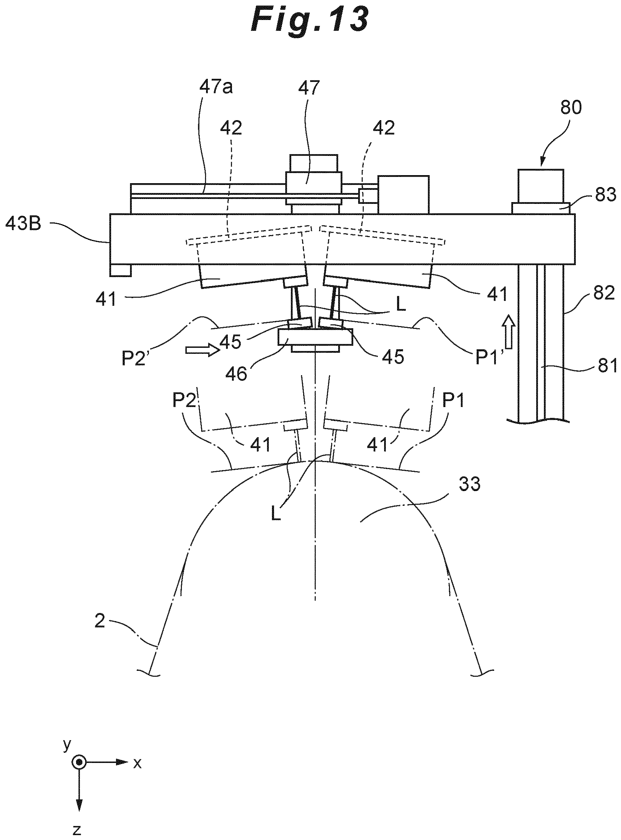

FIG. 13 is a schematic diagram showing a drawing unit including a calibration system according to a third embodiment of the present invention. In the calibration system according to the present embodiment, the exposure head support part 43 for supporting the exposure head 41 moves in translational motion in the vertical plane.

Specifically, the calibration system according to the present embodiment includes an exposure head support part 43B, the sensor unit 45, the sensor unit support part 46, the sensor unit movement part 47, and a movement mechanism 80 for moving the exposure head support part 43B. The movement mechanism 80 includes a support post 81 provided with a rack 82, and a drive part 83 for moving the exposure head support part 43B vertically by rotating a pinion that meshes with the rack 82. The relative positional relationship between the exposure head 41 supported by the exposure head support part 43B and the sensor unit 45 is the same as that of the first embodiment.

When performing calibration, a space is created between the exposure head 41 and the substrate 2 in which the sensor unit 45 can be arranged by moving the exposure head support part 43B in translational motion vertically upward. Then, by sliding the sensor unit support part 46 by means of the sensor unit movement part 47, the sensor unit 46 is arranged at a position where the beam L emitted from the exposure head 41 is to be incident on the light-receiving surface of the optical sensor.

The present invention as thus far described is not limited to the above-described first to third embodiments, and various inventions can be formed by appropriately combining a plurality of components disclosed in the above-described first to third embodiments. For example, such various inventions may be formed by excluding some components from all components shown in the above-described first to third embodiments, or by appropriately combining the components shown in the above-described first to third embodiments.

### DESCRIPTION OF REFERENCE NUMBERS

1... drawing device, 2... substrate, 3... conveying system, 4... drawing unit, 5... controller, 21... exposure pattern, 33... conveying drum, 41... exposure head, 41 a... beam emitting port, 42... adjusting stage, 43, 43A, 43B... exposure head support part, 44... exposure head movement part, 45... sensor unit, 46... sensor unit support part, 47... sensor unit movement part, 47a, 72... slide rail, 48... support stage, 51... external interface, 52... storage part, 53... control part, 61... substrate conveying drive device, 62... exposure head drive device, 63... sensor unit drive device, 64... input device, 65... display device, 66... data reading device, 66... display device, 70... sensor unit fixing part, 71... joist, 73, 83... drive part, 80... movement mechanism, 81... support post, 82... rack, 411... laser light source, 412... beam-shaping optical system, 413, 415... reflecting mirror, 414a... rotary shaft, 414... polygon mirror, 416... fθ lens, 451... optical sensor, 452... sensor substrate, 521... program storage part, 522... drawing data storage part, 523... reference data storage part, 524... calibration data storage part, 525... correction data storage part, 531... drawing control part, 532... calibration control part, 533... determination part, 534... correction part, 535... determination part

## Claims

1. A calibration system for calibrating at least one exposure head that irradiates a substrate having a long-sheet shape with a beam for exposure, the substrate being conveyed along a longitudinal direction, comprising:
an exposure head support part that supports the at least one exposure head, the exposure head support part being configured to be arranged, at the time of exposure, at a position at which the beam emitted from each of the at least one exposure head is to be incident on at least one predetermined exposure region on the substrate;
at least one sensor unit that includes an optical sensor, the optical sensor including a light-receiving surface that receives the beam and detecting at least an irradiation position and an irradiation intensity of the beam incident on the light-receiving surface;
a sensor unit support part that supports the at least one sensor unit, the sensor unit support part supporting the at least one sensor unit so that, at the time of exposure, the light-receiving surface of the optical sensor included in the at least one sensor unit is parallel to an exposure surface in the at least one predetermined exposure region and the sensor unit support part is installed slidably relative to the exposure head support part;
a movement mechanism that is configured to move at least the exposure head support part out of the exposure head support part and the sensor unit support part; and
a control part configured to control operation of the movement mechanism, wherein
the control part is configured to move, at the time of calibration, the exposure head support part so as to create a space in which the at least one sensor unit can be arranged on an optical path of the beam emitted from the at least one exposure head, and to move the sensor unit support part to slide relatively with respect to the exposure head movement part so as to arrange the light-receiving surface at a position corresponding to the exposure surface on which the beam emitted from the at least one exposure head is incident at the time of exposure.

2. The calibration system of claim 1, wherein the movement mechanism includes:
an exposure head movement part that is configured to create the space by lifting one end side of the exposure head support part using the other end side as a rotary shaft; and
a slide movement part that is configured to slide the sensor unit support part relative to the exposure head support part.

3. The calibration system of claim 1, wherein the sensor unit support part is provided at a position fixed relative to a conveying mechanism for conveying the substrate, and
the movement mechanism is configured to move the exposure head support part in translational motion in a direction in which the sliding is possible.

4. The calibration system of claim 1, wherein the movement mechanism includes:
an exposure head movement part that creates the space by moving the exposure head support part in translational motion in the vertical direction; and
a slide movement part that slides the sensor unit support part relative to the exposure head support part.

5. The calibration system of any one of claims 1 to 4, wherein the control part is configured to cause the beam to be emitted from the at least one exposure head toward the light-receiving surface and to generate, based on a detection signal output from the sensor unit, data representing the irradiation position and the irradiation intensity at the light-receiving surface of the beam emitted from the at least one exposure head and
wherein the calibration system further comprises a storage part that is configured to store the data representing the irradiation position and the irradiation intensity as calibration data.

6. The calibration system of claim 5, wherein the storage part is configured to further store reference data representing a reference irradiation position and a reference irradiation intensity of the beam with respect to the at least one exposure region, and
the control part includes a determination part that is configured to determine, based on the calibration data and the reference data, whether or not an irradiation position and an irradiation intensity of a beam emitted from the at least one exposure head fall within ranges of predetermined reference values.

7. The calibration system of claim 6, wherein the control part is configured to generate, based on the determination result by the determination part, correction value data for correcting at least either the irradiation position or the irradiation intensity of the beam emitted from the at least one exposure head if at least either the irradiation position or the irradiation intensity of the beam emitted from the at least one exposure head fails to fall within the range of the reference value, and
the storage part is configured to further store the correction value data.

8. The calibration system of claim 7, wherein each of the at least one exposure heads includes:
a light source that outputs the laser light;
an optical system that shapes the laser light into a beam shape;
a polygon mirror that causes the laser light shaped into the beam shape to scan; and
a drive part that rotates the polygon mirror, wherein
the control part is configured to correct at least either the irradiation intensity or the irradiation position of the beam emitted from the at least one exposure head by controlling at least either the output of the light source or operation of the drive part based on the correction value data.

9. A drawing device comprising:
a calibration system of any one of claims 1 to 8;
at least one exposure head supported by the exposure head support part; and
a conveying drum that has a cylindrical shape, the conveying drum supporting the substrate on an outer periphery and conveying the substrate by rotating about a central shaft of the cylinder.
